# EUROPEAN PATENT SPECIFICATION

(11) **EP 1 709 701 B1**
(45) Date of publication and mention of the grant of the patent: **18.04.2012**
(21) Application number: 04804387.1
(22) Date of filing: 29.12.2004
(51) Int. Cl.: H01L 51/00

(54) **DEPOSITION OF CONDUCTING POLYMERS**
ABLAGERUNG VON LEITENDEN POLYMEREN
DEPOT DE POLYMERES CONDUCTEURS

(30) Priority: 14.01.2004 US 758478
(43) Date of publication of application: 11.10.2006
(73) Proprietor: OSRAM Opto Semiconductors GmbH, 93055 Regensburg (DE)
(72) Inventor: GUPTA, Rahul, MILPITAS, California, CA 95035 (US); INGLE, Andrew, RIO RICO, Arizona AZ 85648 (US); NATARAJAN, Sriram, SALT LAKE CITY, Utah, UT 84108 (US)
(74) Representative: Epping - Hermann - Fischer
(86) International application number: PCT/EP2004/014801
(87) International publication number: WO 2005/069402

(56) References cited:
- EP-A- 1 083 775
- EP-A- 1 372 195
- FR-A- 2 690 567
- GB-A- 1 172 765
- PATENT ABSTRACTS OF JAPAN vol. 016, no. 188 (E-1198), 7 May 1992 (1992-05-07) & JP 04 024970 A (CANON INC), 28 January 1992 (1992-01-28)
- PATENT ABSTRACTS OF JAPAN vol. 010, no. 120 (C-343), 6 May 1986 (1986-05-06) & JP 60 243280 A (ALPS DENKI KK), 3 December 1985 (1985-12-03)

## Description

### BACKGROUND

### 1. Field of the Invention

This invention relates generally to the art of thin film device processing and fabrication. More specifically, the invention relates to the fabrication of Organic Light Emitting Diode based displays and other electronic devices which use selective deposition.

### 2. Related Art

Display and lighting systems based on LEDs (Light Emitting Diodes) have a variety of applications. Such display and lighting systems are designed by arranging a plurality of opto-electronic elements ("elements") such as arrays of individual LEDs. LEDs that are based upon semiconductor technology have traditionally used inorganic materials, but recently, the organic LED ("OLED") has come into vogue for certain applications. Examples of other elements/devices using organic materials include organic solar cells, organic transistors, organic detectors, and organic lasers. There are also a number of bio-technology applications such as biochips for DNA recognition, combinatorial synthesis, etc. which utilize organic materials.

An OLED is typically comprised of two or more thin at least partially conducting organic layers (e.g., an electrically conducting hole transporting polymer layer (HTLs) and an emissive polymer layer where the emissive polymer layer emits light) which are sandwiched between an anode and a cathode. Under an applied forward potential, the anode injects holes into the conducting polymer layer, while the cathode injects electrons into the emissive polymer layer. The injected holes and electrons each migrate toward the oppositely charged electrode and recombine to form an exciton in the emissive polymer layer. The exciton relaxes to a lower energy state by emission of radiation and in process, emits light.

Other organic electronic devices, such as organic transistors and organic sensors will also typically contain a conducting organic (polymer) layer and other organic layers. A number of these OLEDs or other organic electronic devices can be arranged in a pattern over a substrate as for instance in display system. One way of patterning organic electronic devices over a substrate is to create pockets by photo-lithography and then utilize a process known as ink-jet printing. The use of a photo-resist layer to define pockets for inkjet printing is disclosed in published patent application Number US2002/0060518 A1 entitled "Organic Electroluminescent Device and Method of Manufacturing Thereof". In ink-jet printing, polymer or organic solution is deposited by discharging droplets of the solution into the pockets from a print head. One common application of inkjet printing is the patterning of multi-color OLED pixels (such as RGB patterned pixels) in order to manufacture a color display.

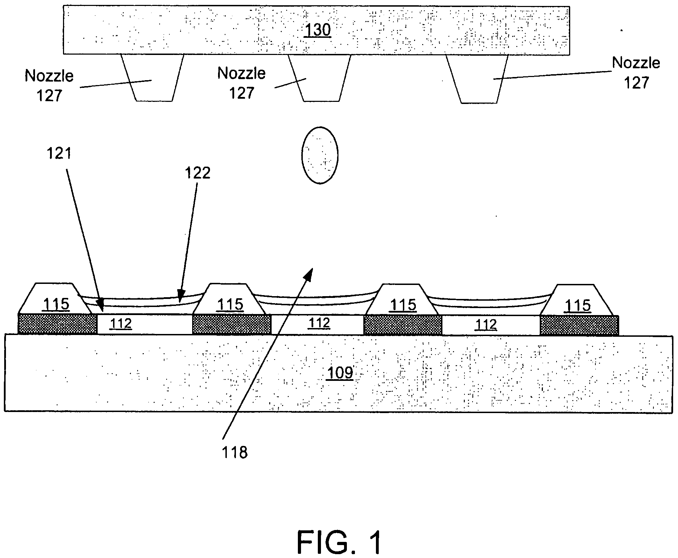

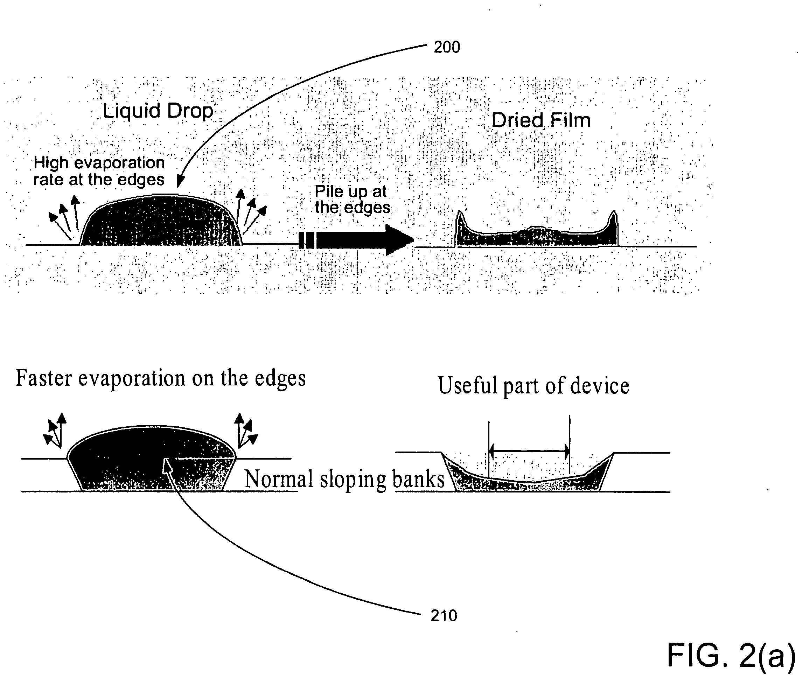

**Figure 1** shows a prior art ink-jet printing system used to deposit a solution. In **Figure 1**, the OLED display that is being fabricated includes a substrate 109 and an anode 112 on the substrate 109. Bank structures 115 are on the anode 112; the bank structure has apertures 118 through which the anode is exposed (the apertures 118 can be pockets or lines). HTLs 121 are on the exposed portions of the anode 112. Emissive polymer layers 122 are on the HTLs 121. Here, the emissive polymer layers 122 are formed by discharging droplets 124 of a solution that includes emissive polymers onto the HTLs and then allowing this emissive polymer solution to dry. The emissive polymer solution is discharged through nozzles 127 of print-head 130. Even if the emissive polymer layers 122 would have a flat or uniform drying profile if they were directly deposited onto anode 112, the presence of the HTLs 121 will affect their profile since they are dried on top of the HTLs 121. Thus, it is important that both HTLs 121 and emissive polymer layers have a flat uniform profile. The HTLs 121 typically, under current state of the art, have very non-uniform and concave profiles as shown in **Figure 2(a)**.

As can be observed, the drying pattern is very non-uniform and shows a piling up on the edges of the drop 200 which represents a drop of a conducting polymer solution. This is due to the difference in the rate of evaporation at different regions of drop 200, resulting in surface tension variations which in turn causes the substance to move towards the edges of the drop 200 from the middle, and hence the ultimate deposition of more of the substance at the edge than in the middle. This phenomenon is usually referred to as the Marangoni effect. A common example of this phenomenon is the drying of a coffee stain which shows more prominence (is darker in color) on the edges of the stain than in the center.

When there are normal sloping photo-resist banks as in the case of drop 210, there is still substantial non-uniformity in the profile of the drop 210 when dried. There is accumulation at the edges which affects the useful part of the device. As the thickness of the dried film increases and becomes less uniform, the current through that part of the film decreases leading to less light being emitted from those parts. This is because in non-uniform areas of the film, the electrical characteristics do not remain very constant. This would leave less of the film that is actually usable in terms of acceptable device performance as shown.

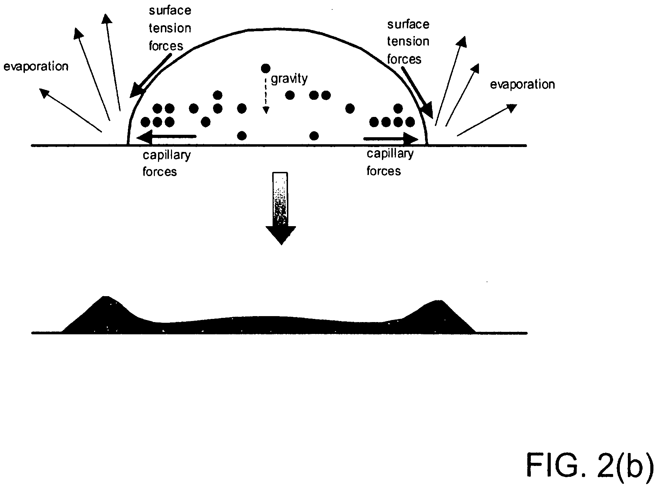

**Figure 2(b)** shows the forces associated with the drying of a liquid solution on a surface. As shown, the liquid solution contains very fine particles (smaller molecules) which have a negligible gravity effect pulling the solution toward the surface. At the edges of the drops, capillary and surface tension forces pull the drop tend to pull the solution toward the edges leading to a pile-up of dried material at those edges. When the film has dried, as shown, the profile is not very uniform and much thicker at the edges than at the middle due to the Marangoni Effect.

It would be desirable to fabricate conducting polymer films that are more uniform in thickness and thus have a flatter profile than is typically observed.

In the document EP 1 372 195 A2, an organic electroluminescent element and a manufacturing process therefore is disclosed.

The document EP 1 083 775 is related to a composition, a method for preparing a film, a functional element and a method for preparing the same.

An organic solar cell is described in the document JP 04-024970 A.

In the document FR 2 690 567 A, electrochemical generators and super condensers are disclosed.

The formation of a transparent electrode is described in the document JP 60-243280 A.

In the document GB 1 172 765 A, protective localized area resin coatings for electroplating are disclosed.

### SUMMARY

In accordance with the invention, a precipitation agent is deposited on a lower electrode layer of an organic electronic device prior to fabrication of organic layers. After the precipitation agent is deposited, organic material is deposited over the precipitation agent. The precipitation agent induces a more uniform and flatter profile when the organic material is allowed to dry into a film on the treated surface.

In one embodiment of the invention, the precipitation agent is spin-coated onto the lower electrode layer. In the case of an OLED which is bottom-emitting, the lower electrode layer functions as an anode and organic material is conducting polymer solution. The organic material is deposited over the precipitation agent and in some cases, can be selectively deposited by ink-jet printing techniques. In embodiments where the organic material is to be inkjet printed into pockets formed over the lower electrode layer, the precipitation agent can also be printed, rather than spin-coated.

### BRIEF DESCRIPTION OF THE DRAWINGS

**Figure 1** illustrates an example of a inkjet printing system for fabricating patterned surfaces.
**Figure 2(a)** illustrates the drying pattern of a liquid substance when the substance is dropped with and without photo-resist.
**Figure 2(b)** shows the forces associated with the drying of a liquid solution on a surface.
**Figure 3(a)** illustrates the forces associated with the drying of an organic solution drop deposited onto and dissolved in a precipitation agent.
**Figure 3(b)** illustrates the resulting drying profile of an organic solution drop deposited onto and dissolved in a precipitation agent.
**Figure 3(c)** illustrates a printing process using precipitation agents in accordance with the invention.
**Figure 4** illustrates a cross-section of the layers of an OLED device.
**Figure 5** shows a workflow of fabricating an OLED using a precipitation agent in accordance with the invention.

### DETAILED DESCRIPTION OF THE INVENTION

In accordance with the invention, the drying profile of a deposited organic (e.g. conducting polymer) solution is modified by depositing a precipitation agent on the deposition surface prior to depositing the organic solution. The precipitation agent induces a more uniform and flatter profile when the organic solution is allowed to dry into a film on the treated surface. In the case of an OLED device, the precipitation agent is deposited on the lower electrode layer, which in a bottom-emitting OLED, is an anode. The use of a precipitation agent yields a substantially uniform and flat profile for the conducting polymer or other organic layer which is formed by drying of deposited organic solution upon the device (over the precipitation agent).

The precipitation agent can be deposited in a variety of ways including but not limited to, spin coating, dip coating and ink jet printing. The precipitation agent is, preferably, 1) soluble in water or water based media, 2) has a solubility of 30% or higher, 3) has a high boiling pint to prevent quick evaporation, and 4) has minimal reactivity with respect to the organic solution. The precipitation agent causes the particles of the organic solution to become "heavy" or larger in size such that the effect of gravity is greater. The increased gravitational effect will compensate in better fashion the capillary and surface tension forces. This will in turn pull the molecules of the organic solution in more of a direction normal to the deposition surface rather than parallel to it. This reduces movement of the solution while drying to the edges and thus, induces a flatter more uniform film.

A process of fabricating an organic electronic device is disclosed whereby 1) a precipitation agent is deposited on a deposition surface and 2) an organic solution is deposited above the precipitation agent. The precipitation agent coalesces with the deposited organic solution and dissolves into the solution. The organic solution is allowed to evaporate and dry into a layer of film which has a substantially flat and uniform profile. After the drying of this organic layer, other steps are carried out to complete the organic electronic device fabrication. Examples of such fabricated organic electronic devices include OLEDs, organic transistors, organic solar cells and so on.

In one embodiment of the invention, the precipitation agent used is propylene carbonate with a boiling point of roughly 240 degrees Celsius. In yet other embodiments of the invention, the precipitation agent used is benzyl alcohol with a boiling point of roughly 205 degrees Celsius. In other embodiments of the invention, the precipitation agent used is dioxane with a boiling point of roughly between 100-102 degrees Celsius. In yet other embodiments of the invention, the precipitation agent can be composed of dicationic salt solutions.

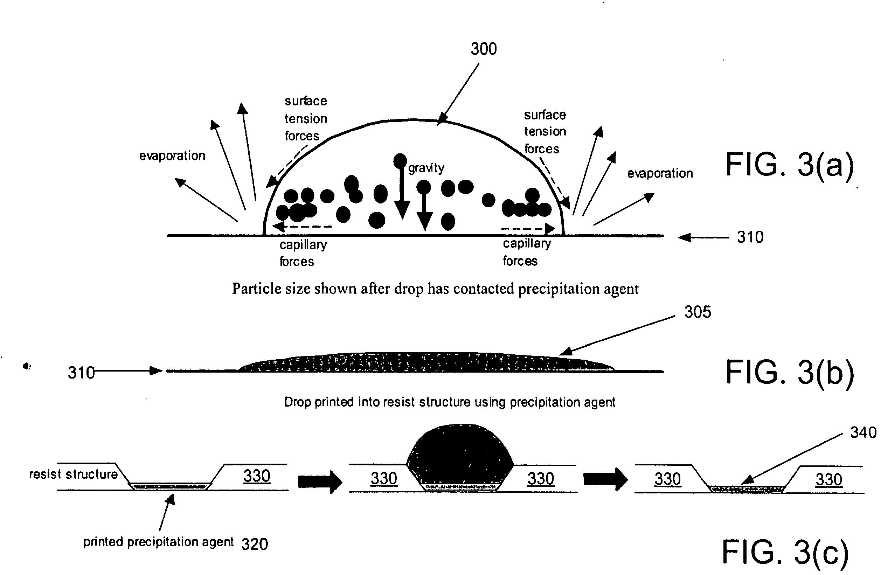

**Figure 3(a)** illustrates the forces associated with the drying of an organic solution drop deposited onto and dissolved in a precipitation agent. In accordance with the invention, the drop 300 of organic solution is deposited over a precipitation agent (not shown separately) into which it dissolves. As shown in **Figure 3(a)**, the precipitation agent causes the particles of the drop to become larger in size and coalesce together to increase their weight and the effect of gravitational force upon them, thus pulling them downward in a direction normal to the deposition surface 310. This will at least partially compensate for the effect of capillary and surface tension related forces which tend to pull the particles of the solution toward the edges of the deposited drop 300.

**Figure 3(b)** illustrates the resulting drying profile of an organic solution drop deposited onto and dissolved in a precipitation agent. As shown, the drop when dried into film 305 exhibits more of a flatter uniform profile. Most notably, as discussed above, the pile-up of solution toward the edges of the dried film 305 is reduced significantly.

**Figure 3(c)** illustrates a printing process using precipitation agents in accordance with the invention.

A precipitation agent 320 is deposited into a pocket shown defined by a photo-resist structure 330 fabricated over a deposition surface. After the precipitation agent 320 is deposited, a drop or drops of organic solution (not labeled) is deposited onto the precipitation agent 320. The organic solution mixes with the precipitation agent 320 causing the particles of the solution to coalesce and become larger. The larger particle size helps to modify the directional dynamics of drying such that less of the solution dries at the edges of the drop than is typical. The solution dries into a uniform flat film 340 due to this interaction, as shown. The solution is assumed in this example to have spread or be of sufficient volume to contact the walls of the photo-resist structure 330 as shown. The organic solution may be a single drop or series of individual drops that have coalesced together into one mass, depending on the volume of liquid, printing technology employed and so on.

In one embodiment of the invention where the device being manufactured is an OLED, the organic solution is a conductive polymer solution which can formed from, for example, polyethylenedioxythiophene ("PEDOT") and polystyrenesulfonic acid ("PSS") (hereinafter "PEDOT:PSS solution"). For a bottom emitting OLED device, the deposition surface would be the surface of an anode layer such as that composed of ITO (Indium Tin-Oxide). Examples of precipitation agents, PEDOT:PSS and other organic solutions and deposition surfaces are discussed below.

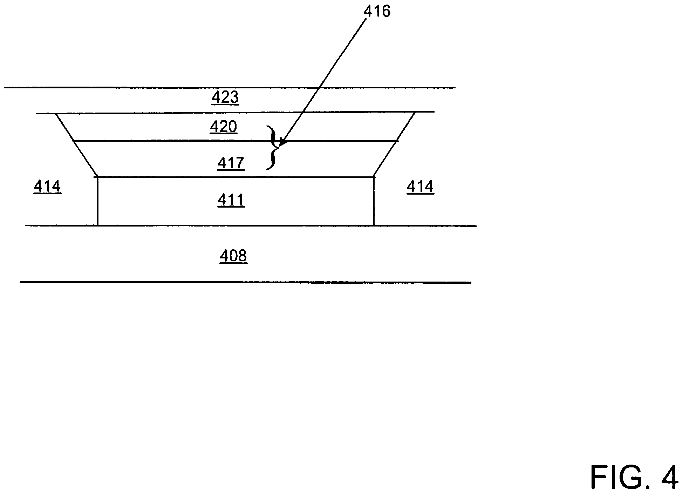

**Figure 4** shows a cross-sectional view of an organic electronic device 405. As shown in **Figure 4**, the organic electronic device 405 includes a first electrode 411 on a substrate 408. As used within the specification and the claims, the term "on" includes when layers are in physical contact and when layers are separated by one or more intervening layers. The first electrode 411 may be patterned for pixilated applications or unpatterned for backlight applications. If the electronic device 405 is a transistor, then the first electrode may be, for example, the source and drain contacts of that transistor. A photo-resist material is deposited on the first electrode 411 and patterned to form a bank structure 414 having an aperture that exposes the first electrode 411. The aperture may be a pocket (e.g., a pixel of an OLED display) or a line. The bank structure 414 is an insulating structure that electrically isolates one pocket from another pocket or one line from another line.

One or more organic materials is deposited into the aperture to form one or more organic layers of an organic stack 416. The organic stack 416 is on the first electrode 411. The organic stack 416 includes a hole transporting (conducting polymer) layer ("HTL") 417 and other active organic layer 420. If the first electrode 411 is an anode, then the HTL 417 is on the first electrode 411. Alternatively, if the first electrode 411 is a cathode, then the active electronic layer 420 is on the first electrode 411, and the HTL 417 is on the active electronic layer 420. The electronic device 405 also includes a second electrode 423 on the organic stack 416. If the electronic device 405 is a transistor, then the second electrode 423 may be, for example, the gate contact of that transistor. Other layers than that shown in Figure 4 may also be added including insulating layers between the first electrode 411 and the organic stack 416, and/or between the organic stack 416 and the second electrode 423. Some of these layers are described in greater detail below.

### Substrate 408:

The substrate 408 can be any material that can support the organic and metallic layers on it. The substrate 408 can be transparent or opaque (e.g., the opaque substrate is used in top-emitting devices). By modifying or filtering the wavelength of light which can pass through the substrate 408, the color of light emitted by the device can be changed. The substrate 408 can be comprised of glass, quartz, silicon, plastic, or stainless steel; preferably, the substrate 408 is comprised of thin, flexible glass. The preferred thickness of the substrate 408 depends on the material used and on the application of the device. The substrate 408 can be in the form of a sheet or continuous film. The continuous film can be used, for example, for roll-to-roll manufacturing processes which are particularly suited for plastic, metal, and metallized plastic foils. The substrate can also have transistors or other switching elements built in to control the operation of the device.

### First Electrode 411:

In one configuration, the first electrode 411 functions as an anode (the anode is a conductive layer which serves as a hole-injecting layer and which comprises a material with work function greater than about 4.5 eV). Typical anode materials include metals (such as platinum, gold, palladium, indium, and the like); metal oxides (such as lead oxide, tin oxide, ITO, and the like); graphite; doped inorganic semiconductors (such as silicon, germanium, gallium arsenide, and the like); and doped conducting polymers (such as polyaniline, polypyrrole, polythiophene, and the like).

The first electrode 411 can be transparent, semi-transparent, or opaque to the wavelength of light generated within the device. The thickness of the first electrode 411 is from about 10nm to about 1000nm, preferably, from about 50nm to about 200nm, and more preferably, is about 100nm. The first electrode layer 411 can typically be fabricated using any of the techniques known in the art for deposition of thin films, including, for example, vacuum evaporation, sputtering, electron beam deposition, or chemical vapor deposition.

In an alternative configuration, the first electrode layer 411 functions as a cathode (the cathode is a conductive layer which serves as an electron-injecting layer and which comprises a material with a low work function). The cathode, rather than the anode, is deposited on the substrate 408 in the case of, for example, a top-emitting OLED. Typical cathode materials are listed below in the section for the "second electrode 423".

### Bank Structure 414:

The bank structure 414 is made of a photo-resist material such as, for example, polyimides or polysiloxanes. The photo-resist material can be either positive photo-resist material or negative photo-resist material. The bank structure 414 is an insulating structure that electrically isolates one pocket from another pocket or one line from another line. The bank structure 414 has an aperture 415 that exposes the first electrode 411. The aperture 415 may represent a pocket or a line. The bank structure 414 is patterned by applying lithography techniques to the photo-resist material, or by using screen printing or flexo-printing to deposit the bank material in the desired pattern. As shown in **Figure 4**, the bank structure 414 can have, for example, a trapezoidal configuration in which the angle between the side wall of the bank structure 414 and the first electrode 411 is an obtuse angle. Alternatively, the bank structure can be semicircular or curved in nature.

### HTL 417:

The HTL 417 has a much higher hole mobility than electron mobility and is used to effectively transport holes from the first electrode 411 to the substantially uniform organic polymer layer 420. The HTL 417 is made of polymers or small molecule materials. For example, the HTL 417 can be made of tertiary amine or carbazole derivatives both in their small molecule or their polymer form, conducting polyaniline ("PANI"), or PEDOT:PSS. The HTL 417 has a thickness from about 5nm to about 1000 nm, preferably from about 20nm to about 500 nm, and more preferably from about 50 to about 250 nm.

The HTL 417 functions as: (1) a buffer to provide a good bond to the substrate; and/or (2) a hole injection layer to promote hole injection; and /or (3) a hole transport layer to promote hole transport.

The HTL 417 can be deposited using selective deposition techniques or nonselective deposition techniques. Examples of selective deposition techniques include, for example, ink jet printing, flex printing, and screen printing. Examples of nonselective deposition techniques include, for example, spin coating, dip coating, web coating, and spray coating. If printing techniques are used, then the hole transporting material is deposited on the first electrode 411 and then allowed to dry. The dried material represents the hole transport layer.

As mentioned above, in accordance with the invention, a precipitation agent is deposited on the first electrode layer 411 prior to any deposition of the organic material used to form HTL 417. One example of a typical HTL material is PEDOT:PSS solution such as Baytron P AI4083 which has a PEDOT to PSS ratio of one part to six parts. The addition of a precipitation agent on first electrode 411 prior to deposition of the HTL material, yields a dried HTL 417 which is more uniform and flat in profile than is typically the case. The use of Baytron P AI4083, which is manufactured by H.C. Starck, a division of Bayer AG, is merely exemplary however.

The invention can serve to provide a flat and uniform drying profile of any PEDOT:PSS solution or any organic solution through deposition of a precipitation agent on the surface (e.g. first electrode 411) on which the solution is to be dried. Exemplary precipitation agents which can be deposited for use with conducting polymer solutions are: 1) Dioxane with a boiling point of around 100-102°C, 2) Propylene Carbonate with a boiling point of around 240°C, 3) Benzyl Alcohol with a boiling point of around 205°C, and 4) highly concentrated dicationic salts such as calcium chloride and/or magnesium sulfate as long as the salts are water soluble such as to cause precipitation.

### Active Electronic Layer 420:

Active electronic layer 420 can include one or more layers. Active electronic layer 420 includes an active electronic material. Active electronic materials can include a single active electronic material, a combination of active electronic materials, or multiple layers of single or combined active electronic materials. Preferably, at least one active electronic material is organic.

For organic LEDs (OLEDs), the active electronic layer 316 contains at least one organic material that emits light. These organic light emitting materials generally fall into two categories. The first category of OLEDs, referred to as polymeric light emitting diodes, or PLEDs, utilize polymers as part of active electronic layer 420. The polymers may be organic or organometallic in nature. As used herein, the term organic also includes organometallic materials. Preferably, these polymers are solvated in an organic solvent, such as toluene or xylene, and spun (spin-coated) onto the device, although other methods are possible. Devices utilizing polymeric active electronic materials in active electronic layer 316 are especially preferred. In addition to materials that emit light, active electronic layer 420 may include a light responsive material that changes its electrical properties in response to the absorption of light. Light responsive materials are often used in detectors and solar panels that convert light energy to electrical energy.

If the organic electronic device is an OLED or an organic laser, then the organic polymers are electroluminescent ("EL") polymers that emit light. The light emitting organic polymers can be, for example, EL polymers having a conjugated repeating unit, in particular EL polymers in which neighboring repeating units are bonded in a conjugated manner, such as polythiophenes, polyphenylenes, polythiophenevinylenes, or poly-p-phenylenevinylenes or their families, copolymers, derivatives, or mixtures thereof. More specifically, the organic polymers can be, for example: polyfluorenes; poly-p-phenylenevinylenes that emit white, red, blue, yellow, or green light and are 2-, or 2, 5- substituted poly-p-pheneylenevinylenes; polyspiro polymers.

If the organic electronic device is an organic solar cell or an organic light detector, then the organic polymers are light responsive material that changes its electrical properties in response to the absorption of light. The light responsive material converts light energy to electrical energy.

If the organic electronic device is an organic transistor, then the organic polymers can be, for example, polymeric and/or oligomeric semiconductors. The polymeric semiconductor can comprise, for example, polythiophene, poly(3-alkyl)thiophene, polythienylenevinylene, poly(para-phenylenevinylene), or polyfluorenes or their families, copolymers, derivatives, or mixtures thereof.

In addition to polymers, smaller organic molecules that emit by fluorescence or by phosphorescence can serve as a light emitting material residing in active electronic layer 316. Unlike polymeric materials that are applied as solutions or suspensions, small-molecule light emitting materials are preferably deposited through evaporative, sublimation, or organic vapor phase deposition methods. Combinations of PLED materials and smaller organic molecules can also serve as active electronic layer. For example, a PLED may be chemically derivatized with a small organic molecule or simply mixed with a small organic molecule to form active electronic layer 316.

In addition to active electronic materials that emit light, active electronic layer 420 can include a material capable of charge transport. Charge transport materials include polymers or small molecules that can transport charge carriers. For example, organic materials such as polythiophene, derivatized polythiophene, oligomeric polythiophene, derivatized oligomeric polythiophene, pentacene, compositions including C60, and compositions including derivatized C60 may be used. Active electronic layer 420 may also include semiconductors, such as silicon or gallium arsenide.

### Second Electrode (423)

In one embodiment, second electrode 423 functions as a cathode when an electric potential is applied across the first electrode 411 and second electrode 423. In this embodiment, when an electric potential is applied across the first electrode 411, which serves as the anode, and second electrode 423, which serves as the cathode, photons are released from active electronic layer 420 that pass through first electrode 411 and substrate 408.

While many materials, which can function as a cathode, are known to those of skill in the art, most preferably a composition that includes aluminum, indium, silver, gold, magnesium, calcium, and barium, or combinations thereof, or alloys thereof, is utilized.

Preferably, the thickness of second electrode 423 is from about 10 to about 1000 nanometers (nm), more preferably from about 50 to about 500 nm, and most preferably from about 100 to about 300 nm. While many methods are known to those of ordinary skill in the art by which the first electrode material may be deposited, vacuum deposition methods, such as physical vapor deposition (PVD) are preferred. Other layers (not shown) such as a barrier layer and getter layer may also be used to protect the electronic device. Such layers are well-known in the art and are not specifically discussed herein.

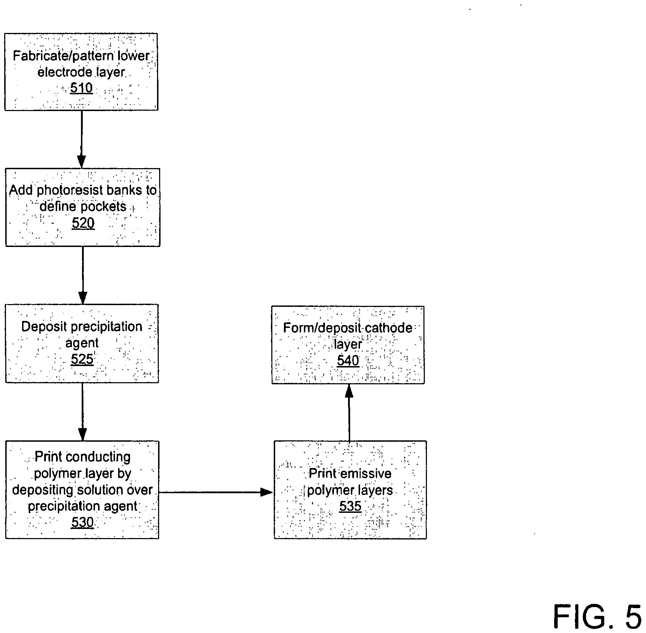

**Figure 5** shows a workflow of fabricating an organic electronic device in accordance with the invention. First, a lower electrode layer is fabricated/patterned over a substrate (step 510). The lower electrode layer preferably functions as an anode in the case of an OLED device. Typical anode materials include metals (e.g. aluminum, silver, copper, indium, tungsten, lead etc.); metal oxides; graphite; doped inorganic semiconductors (such as doped silicon, gallium arsenide and the like); and doped conducting polymers (such as polyaniline, polythiopene and the like). For OLEDs, the lower electrode layer is usually thin enough so as to be semi-transparent and allow at least a fraction of light to transmit through (in bottom emitting OLEDs). As such, any thin-film deposition method may be used in the fabricating step 510. These include, but are not limited to, vacuum evaporation, sputtering, electron beam deposition, chemical vapor deposition, etching and other techniques known in the art and combinations thereof. The process also usually involves a baking or annealing step in a controlled atmosphere to optimize the conductivity and optical transmission of anode layer. Photolithography can then be used to define any pattern in the lower electrode layer.

The next step is to add a photo-resist bank structure such that pockets in the anode layer are defined (step 520). The photo-resist banks are fabricated by applying lithography techniques to a photo-resist material (or by using screen printing or flexo-graphic printing to deposit the bank material in the desired pattern). Photo-resist material is usually classified in two types, either positive or negative. Positive photo-resist is photo-resist which dissolves wherever exposed to light. Negative photo-resist is photo-resist which dissolves everywhere except where exposed to light. Either positive or negative photo-resist can be used as desired in forming the photo-resist banks. Photo-resist chemistry and processes such as lithography, baking, developing, etching and radiation exposure which can be used in patterning the photo-resist into banks are known to those skilled in the art.

In accordance with the invention, the next step is to deposit a precipitation agent into the pocket(s) defined by the photo-resist structure (step 525). The precipitation agent will modify the molecular properties of the conducing polymer solution that follows it, making the molecules larger and more susceptible to gravitational forces. In one embodiment of the invention, the precipitation agent is printed using a selective deposition technique. In alternative embodiments of the invention, step 525 may instead precede step 520 such that the precipitation agent is deposited prior to fabrication of the photo-resist structure. In such embodiments, the precipitation agent can be spin coat deposited or dipped/rolled.

Next, the conducting polymer layer is printed by depositing a conducting polymer solution (step 530) over the precipitation agent. The conducting polymer layer is preferably applied using printing techniques such as ink-jet printing (screen printing, flexo-graphic printing). Particularly, in this instance, the conducting polymer layer is printed within pockets defined by photo-resist banks. The conducting polymer layer is printed by depositing the organic solution into the pocket over the precipitation agent and allowing the mixture to dry. The dried film then represents the conducting polymer layer. The addition of the precipitation agent enables the conducting polymer layer to have a uniformly flat profile after drying is complete. The conducting polymer layer is also referred to as a hole transport layer ("HTL"). The conducting polymer layer is used to improve, for example, the charge balance, the display stability, the turn-on voltage, the display brightness, the display efficiency, and the display lifetime. The conducting polymer layer is used to enhance the hole yield of the OLED relative to the potential applied across it and thus, aids in more energy-efficient injection of holes into the emissive polymer layer for recombination.

Then according to step 535, the emissive polymer layers are printed. The emissive polymer layer is primarily responsible for the emission of light from the OLED and is thus a electroluminescent, semi-conducting and organic (organo-metallic) type material as discussed above. In inkjet printing, there may be a plurality of different emissive polymer substances. For instance, there may be red, green and blue emitting emissive polymers in the print head which are deposited depending upon the desired color to be emitted in a given pixel location which is defined by a pocket. The emitting polymer substances are deposited on the conducting polymer layer by the print head in the exact area defined by the pockets. The emissive polymer layer results from the drying of the substance deposited by the print head.

Both the conducting polymer layers and emissive polymer layers can be printed by depositing a liquid solution in between the photo-resist banks which define a pocket. This liquid solution may be any "fluid" or deformable mass capable of flowing under pressure and may include solutions, inks, pastes, emulsions, dispersions and so on. The liquid may also contain or be supplemented by further substances which affect the viscosity, contact angle, thickening, affinity, drying, dilution and so on of the deposited drops.

After the emissive polymer layer is printed, the upper electrode layer is formed/deposited (step 540). In OLED devices, the upper electrode layer functions as a cathode (if the lower electrode layer is the anode). Cathode layer materials are discussed above. Insulating materials such as LiF, NaF, CsF and so on may also be used below the upper electrode layer to enhance injection by tunneling. The lower electrode layer is formed/deposited typically using vacuum evaporation or similar techniques and often using specially designed deposition devices. Often other steps such as the addition of masks and photo-resists may precede the cathode deposition step 540. However, these are not specifically enumerated as they do not relate specifically to the novel aspects of the invention. Other steps (not shown) like adding metal lines to connect the anode lines to power sources may also be included in the workflow. The workflow of **Figure 5** is not intended to be all-inclusive and is merely exemplary. For instance, after the OLED is fabricated it is often encapsulated to protect the layers from environmental damage or exposure. Such other processing steps are well-known in the art and are not a subject of the invention.

The introduction of a precipitation agent can serve to provide a flat and uniform drying profile of any conducting polymer solution or any organic solution which is deposited thereon. The invention is not thus limited to any one type of precipitation agent or type of deposited solution.

While the embodiments of the invention are illustrated in which it is primarily incorporated within an OLED display, almost any type of electronic device that uses dried film layers may be potential applications for these embodiments. In particular, present invention may also be utilized in a solar cell, a transistor, a phototransistor, a laser, a photodetector, or an opto-coupler. It can also be used in biological applications such as bio-sensors or chemical applications such as applications in combinatorial synthesis etc. The OLED display described earlier can be used within displays in applications such as, for example, computer displays, information displays in vehicles, television monitors, telephones, printers, and illuminated signs.

## Claims

1. A method of fabricating an organic electronic device, said method comprising:
patterning a lower electrode layer (411) upon a substrate (408), said lower electrode layer having a top exposed surface;
depositing a precipitation agent (320) upon said lower electrode layer;
depositing an organic solution (300) upon said precipitation agent, wherein said organic solution mixes with the precipitation agent causing the particles of said organic solution to coalesce and to become larger; and drying said mixture of said organic solution and said precipitation agent into an organic layer (305).

2. A method according to claim 1 wherein said precipitation agent (320) is deposited by spin coating.

3. A method according to claim 1 wherein said organic electronic device is an organic light emitting diode (OLED) display.

4. A method according to claim 3 wherein said lower electrode layer (411) functions as an anode.

5. A method according to claim 4 wherein said organic layer (305) is a conducting polymer layer (417).

6. A method according to claim 5 further comprising:
fabricating an emissive layer above said conducting polymer layer (417), said emissive layer emitting light upon charge recombination.

7. A method according to claim 6 further comprising:
fabricating a photo-resist layer (330) upon said lower electrode layer (411), said photo-resist layer patterned into a plurality of banks to define pockets upon said lower electrode layer.

8. A method according to claim 7 wherein said precipitation agent (320) is printed into said pockets.

9. A method according to claim 7 wherein said organic solution (300) is deposited by printing.

10. A method according to claim 1 wherein said device is an organic transistor.

11. A method according to claim 1 wherein said device is an organic solar cell.

12. A method according to claim 1 wherein said precipitation agent (320) includes at least one of dioxane, propylene carbonate, and benzyl alcohol.

13. A method according to claim 1 wherein said precipitation agent (320) includes a dicationic salt.

14. A method according to claim 1, wherein said mixture of organic solution (300) and precipitation agent (320) dries into a uniform flat film (340).

## Patentansprüche

1. Verfahren zur Herstellung einer organischen elektronischen Vorrichtung, wobei dieses Verfahren Folgendes umfasst:
Strukturieren einer unteren Elektrodenschicht (411) auf einem Substrat (408), wobei diese untere Elektrodenschicht eine obere freiliegende Oberfläche aufweist;
Aufbringen eines Ausfällungsmittels (320) auf die untere Elektrodenschicht;
Aufbringen einer organischen Lösung (300) auf das Ausfällungsmittel, wobei sich diese organische Lösung mit dem Ausfällungsmittel vermischt, was bewirkt, dass die Partikel der organischen Lösung koaleszieren und
größer werden; und Trocknen des Gemischs aus der organischen Lösung und dem Ausfällungsmittel zu einer organischen Schicht (305).

2. Verfahren nach Anspruch 1, bei dem das Ausfällungsmittel (320) mittels Rotationsbeschichtung aufgebracht wird.

3. Verfahren nach Anspruch 1, bei dem die organische elektronische Vorrichtung ein organisches Leuchtdioden-(OLED) -Display ist.

4. Verfahren nach Anspruch 3, bei dem die untere Elektrodenschicht (411) als Anode dient.

5. Verfahren nach Anspruch 4, bei dem die organische Schicht (305) eine leitende Polymerschicht (417) ist.

6. Verfahren nach Anspruch 5, ferner umfassend:
Herstellen einer Emissionsschicht über der leitenden Polymerschicht (417), wobei diese Emissionsschicht bei Ladungsrekombination Licht emittiert.

7. Verfahren nach Anspruch 6, ferner umfassend:
Herstellen einer Fotolackschicht (330) auf der unteren Elektrodenschicht (411), wobei diese Fotolackschicht in eine Vielzahl von Bänken strukturiert ist, um Taschen auf der unteren Elektrodenschicht zu definieren.

8. Verfahren nach Anspruch 7, bei dem das Ausfällungsmittel (320) in die Taschen gedruckt wird.

9. Verfahren nach Anspruch 7, bei dem die organische Lösung (300) durch Drucken aufgebracht wird.

10. Verfahren nach Anspruch 1, wobei die Vorrichtung ein organischer Transistor ist.

11. Verfahren nach Anspruch 1, wobei die Vorrichtung eine organische Solarzelle ist.

12. Verfahren nach Anspruch 1, bei dem das Ausfällungsmittel (320) mindestens eines von Dioxan, Propylencarbonat und Benzylalkohol ist.

13. Verfahren nach Anspruch 1, bei dem das Ausfällungsmittel (320) ein dikationisches Salz umfasst.

14. Verfahren nach Anspruch 1, bei dem das Gemisch aus organischer Lösung (300) und Ausfällungsmittel (320) zu einem gleichförmigen ebenen Überzug (340) trocknet.

## Revendications

1. Procédé de fabrication d'un dispositif électronique organique, ledit procédé comprenant:
configuration d'une couche d'électrode inférieure (411) sur un substrat (408), ladite couche d'électrode inférieure ayant une surface exposée supérieure ;
dépôt d'un agent de précipitation (320) sur ladite couche d'électrode inférieure ;
dépôt d'une solution organique (300) sur ledit agent de précipitation, ladite solution organique se mélangeant avec l'agent de précipitation en ayant pour effet la coalescence des particules de ladite solution organique et leur élargissement ; et séchage dudit mélange de ladite solution organique et dudit agent de précipitation avec obtention d'une couche organique (305).

2. Procédé selon la revendication 1, dans lequel ledit agent de précipitation (320) est déposé par enduction centrifuge.

3. Procédé selon la revendication 1, dans lequel ledit dispositif électronique organique est un écran à diode électroluminescente organique (OLED).

4. Procédé selon la revendication 3, dans lequel ladite couche d'électrode inférieure (411) fonctionne en tant qu'une anode.

5. Procédé selon la revendication 4, dans lequel ladite couche organique (305) est une couche de polymère conducteur (417).

6. Procédé selon la revendication 5, comprenant en outre :
fabrication d'une couche émissive sur ladite couche de polymère conducteur (417), ladite couche émissive émettant la lumière par recombinaison de charge.

7. Procédé selon la revendication 6, comprenant en outre :
fabrication d'une couche photosensible (330) sur ladite couche d'électrode inférieure (411), ladite couche photosensible étant structurée en une pluralité de gradins pour définir des poches au-dessus de ladite couche d'électrode inférieure.

8. Procédé selon la revendication 7, dans lequel ledit agent de précipitation (320) est imprimé dans lesdites poches.

9. Procédé selon la revendication 7, dans lequel ladite solution organique (300) est déposée par impression.

10. Procédé selon la revendication 1, dans lequel ledit dispositif est un transistor organique.

11. Procédé selon la revendication 1, dans lequel ledit dispositif est une cellule solaire organique.

12. Procédé selon la revendication 1, dans lequel ledit agent de précipitation (320) comprend au moins une des substances suivantes : dioxane, carbonate de propylène et alcool benzylique.

13. Procédé selon la revendication 1, dans lequel ledit agent de précipitation (320) comprend un sel dicationique.

14. Procédé selon la revendication 1, dans lequel ledit mélange de solution organique (300) et d'agent de précipitation (320) sèche en formant un film plat uniforme (340).
